# DEMANDE DE BREVET EUROPEEN

(11) **EP 1 164 592 A1**
(43) Date de publication de la demande: **19.12.2001**
(21) Numéro de dépôt: 01401425.2
(22) Date de dépôt: 01.06.2001
(51) Int. Cl.: G11C 7/10, G11C 11/4099, G11C 11/4094

(54) **Dispositif de mémoire vive dynamique et procédé de commande d'un accès en lecture d'une telle mémoire**

(30) Priorité: 13.06.2000 FR 0007522
(71) Demandeur: STMicroelectronics S.A., 92120 Montrouge (FR)
(72) Inventeur: Jacquet, Francois, 38000 Grenoble (FR); Goducheau, Olivier, 38000 Grenoble (FR)
(74) Mandataire: Casalonga, Axel

(57) **Abrégé**

Chaque cellule-mémoire (CM) étant connectée à une ligne de bit (BL) du plan-mémoire et associée à une cellule de référence principale (DCMP) connectée à une ligne de bit de référence (BLN), il est prévu une phase de lecture et de rafraîchissement du contenu de la cellule-mémoire et une phase de précharge de la ligne de bit, de la ligne de bit de référence et de la cellule de référence principale en vue d'un accès en lecture ultérieur. On active, au cours de la phase de lecture et de rafraîchissement de la cellule-mémoire, la cellule de référence principale (DCMP) et une cellule de référence secondaire (DCMS) connectée à la ligne de bit et, après avoir désactivé les deux cellules de référence, on les précharge à une tension de précharge finale (VREF) choisie inférieure ou supérieure, en fonction de la technologie NMOS ou PMOS utilisée, à la demi-somme de la tension de mémorisation d'état haut et de la tension de mémorisation d'état bas, en les reliant à une ligne capacitive (MCAL) distincte de la ligne de bit et de la ligne de bit de référence et ayant un potentiel prédéterminé et une valeur capacitive prédéterminée.

## Description

L'invention concerne les mémoires vives dynamiques (DRAM : "Dynamic Random Access Memory" en langue anglaise), et notamment la commande des accès en lecture / réécriture et plus particulièrement la précharge des cellules de référence associées aux cellules-mémoire de la mémoire.

L'invention s'applique avantageusement mais non limitativement aux mémoires dynamiques dites "embarquées" ("embedded DRAM" en langue anglaise), c'est-à-dire des mémoires qui sont par exemple réalisées conjointement à d'autres composants par un même procédé (process) technologique, et destinés à être intégrés ensemble au sein d'un circuit intégré spécifique (ASIC).

Par opposition aux mémoires vives statiques (SRAM), dans laquelle l'information mémorisée le reste indéfiniment du moins tant que cette mémoire reste alimentée, les mémoires dynamiques présentent la particularité de nécessiter un rafraîchissement périodique de l'information stockée en raison notamment des courants de fuite parasites qui déchargent la capacité de stockage de chaque point mémoire.

Parmi les cellules de mémoire vives dynamiques, on peut notamment citer celles comportant un, deux ou trois transistors.

Classiquement, les mémoires vives dynamiques sont organisées en lignes et en colonnes de cellules-mémoire. Chaque colonne comporte une métallisation communément appelée "ligne de bit" (bit line en langue anglaise) et une ligne de bit immédiatement adjacente appelée ligne de bit de référence ou "bit line not". Il est par ailleurs prévu des moyens de précharge par colonne pour précharger la ligne de bit et la ligne de bit de référence de la colonne avant un accès en lecture de la mémoire. La précharge de ligne de bit et des lignes de bit de référence s'effectue généralement à une tension égale à Vdd/2 dans le cas où la tension d'alimentation Vdd représente la tension de mémorisation d'un état haut (typiquement un "1" logique) et 0 volt (la masse) représente la tension de mémorisation d'un état bas (typiquement un "0" logique).

La plupart des mémoires DRAM utilisent une rangée de cellules dites de "référence", également connectées sur les lignes de bit et les lignes de bit de référence, pour égaliser les charges des lignes de bit et des lignes de bit de référence et maximiser l'amplitude moyenne du signal entre les "0" et les "1".

Il est également prévu d'autres moyens de précharge pour précharger cette rangée de cellules dites de "référence". La précharge des cellules de référence s'effectue également généralement à Vdd/2.

Lors d'un accès en lecture d'une cellule-mémoire connectée sur une ligne de bit, on sélectionne (on active) cette cellule et la cellule de référence connectée sur la ligne de bit de référence, puis on détecte le signe de la différence de tension entre la ligne de bit et la ligne de bit de référence de façon à déterminer le contenu logique 0 ou 1 de la cellule-mémoire.

Cette détection s'effectue classiquement à l'aide d'un amplificateur de lecture/réécriture, connecté entre la ligne de bit et la ligne de bit de référence. Cet amplificateur comporte généralement deux inverseurs rebouclés (formant une bascule bi-stable), formés chacun de deux transistors complémentaires et commandés par deux signaux successifs de lecture et de réécriture (communément dénommés respectivement "sense" et "restore" en langue anglaise).

Lors de l'activation du signal "restore", la donnée lue dans la mémoire est réécrite, rafraîchissant ainsi le contenu de cette cellule.

Une telle structure classique de mémoire présente certains inconvénients.

Un premier inconvénient réside dans la valeur de la tension de précharge des cellules de référence. En effet, en raison des courants de fuite parasites qui déchargent la capacité de stockage de chaque point stockant un "1" logique (en technologique NMOS), la tension de la ligne de bit lorsque la cellule-mémoire est sélectionnée, est inférieure à Vdd et la différence de tension entre la ligne de bit et la ligne de bit de référence lors de la lecture de la cellule-mémoire peut en être réduite.

Ceci est particulièrement gênant si cette différence de tension devient inférieure à la tension de décalage (offset) de l'amplificateur de lecture / réécriture car cela peut conduire à un rafraîchissement erroné de la cellule-mémoire (un 1 est réécrit alors qu'un "0" est lu et vice-versa).

Ce problème se pose notamment pour une mémoire qui reste inactive (c'est-à-dire sans accès lecture) pendant un temps relativement long, ou bien pour une mémoire DRAM embarquée pour laquelle le process utilisé privilégie plus la vitesse de propagation des signaux, ce qui conduit par conséquent à une augmentation des courants de fuite.

Un deuxième inconvénient de la structure de l'art antérieur réside dans les moyens utilisés pour le retour à la valeur de précharge des cellules de référence. En effet, ce retour est assuré par l'utilisation d'un générateur de tension continue qui est commun à l'ensemble des cellules de référence. Or, la conception d'un tel générateur est particulièrement difficile en raison notamment de la capacité de charge importante (typiquement 1024 cellules de référence ayant chacune une capacité de 30 fF), de la forte excursion de tension nécessaire et des fréquences rapides (50-100 MHZ pour les générations de mémoire courante). La conception d'un tel générateur est d'autant plus difficile à basse tension et la consommation statique est élevée pour atteindre les performances nécessaires. En outre, il est particulièrement difficile de distribuer la tension générée à travers toute la mémoire en raison des capacités parasites et des diverses résistances.

Enfin, l'opération de précharge est fortement dépendante des données lues ou écrites.

L'invention vise à apporter une solution à ces problèmes.

Un but de l'invention est de précharger les cellules de référence à une valeur de précharge rendant la lecture des données moins sensible au problème de fuites de courant.

L'invention a également pour but de s'affranchir de l'utilisation d'un générateur continu pour établir le potentiel de précharge des cellules de référence, c'est-à-dire pour précharger ces cellules.

L'invention a encore pour but de proposer un mécanisme de précharge qui soit efficace à basse tension, qui soit plus rapide, ce qui se traduit par une augmentation de la fréquence de fonctionnement de la mémoire.

L'invention propose donc un procédé de commande d'un accès en lecture d'une cellule-mémoire d'un plan-mémoire d'un dispositif de mémoire vive dynamique. Dans une telle mémoire, la cellule-mémoire est connectée à une ligne de bit du plan mémoire et est associée à une cellule de référence dite cellule de référence principale, connectée à une ligne de bit de référence. Ce procédé comporte une phase de lecture et de rafraîchissement du contenu de la cellule-mémoire et une phase de précharge de la ligne de bit, de la ligne de bit de référence et de la cellule de référence principale en vue d'un accès en lecture ultérieure.

Selon une caractéristique générale de l'invention, on active, au cours de la phase de lecture et de rafraîchissement de la cellule-mémoire, la cellule de référence principale et une cellule de référence dite cellule de référence secondaire, connectée à la ligne de bit, et, après avoir désactivé les deux cellules de référence, on les précharge à une tension de précharge finale choisie inférieure ou supérieure en fonction de la technologie NMOS ou PMOS utilisée, à la demi somme de la tension de mémorisation d'état haut et de la tension de mémorisation d'état bas, et ce, en les reliant à une ligne capacitive distincte de la ligne de bit et de la ligne de bit de référence cette ligne capacitive ayant un potentiel prédéterminé et une valeur capacitive prédéterminée.

L'invention utilise donc un mécanisme de partage de charges pour précharger les cellules de référence. Ce mécanisme de partage de charges est particulièrement efficace à basse tension. Il est établi localement, ce qui permet une augmentation des performances (précharge plus rapide), ce qui se traduit par l'augmentation de la fréquence de fonctionnement de la mémoire. Il est donc inutile de prévoir un générateur continu pour établir le potentiel de précharge des cellules de référence. Ce qui conduit donc à une économie de consommation ainsi qu'à un gain de surface.

Par ailleurs, ce mécanisme de partage de charge utilisant une ligne capacitive ayant un potentiel prédéterminé et une valeur capacitive prédéterminée, permet de précharger les cellules de référence à une tension de précharge qui est différente de la demi somme de la tension de mémorisation d'état haut et de la tension de mémorisation d'état bas (typiquement différente de Vdd/2).

Ainsi, à titre d'exemple la tension de précharge finale des cellules de référence peut être égale au tiers de la somme de la tension de mémorisation d'état haut et de la tension de mémorisation d'état bas (par exemple Vdd/3) pour une technologie NMOS et aux deux tiers de cette somme (2Vdd/3) pour une technologie PMOS.

Selon une variante de l'invention, on active les deux cellules de référence au cours de la phase de lecture et de rafraîchissement de façon à précharger les deux cellules de référence avec deux potentiels intermédiaires de précharge respectivement égaux aux tensions de mémorisation d'état haut et d'état bas, puis on désactive la cellule-mémoire rafraîchie et les deux cellules de référence, avant de précharger la ligne de bit et la ligne de bit de référence, et de relier les deux cellules de référence à ladite métallisation capacitive portée audit potentiel prédéterminé.

En d'autres termes, selon cette variante, la cellule-mémoire rafraîchie et les cellules de référence sont désélectionnées (isolées des lignes de bit). Les cellules de référence principale et secondaire restent alors chargées à un état opposé, ainsi que les lignes de bit. La ligne de bit et la ligne de bit de référence sont ensuite préchargées, par exemple à la tension Vdd/2 par un mécanisme d'égalisation. Le potentiel de précharge final des cellules de référence est alors obtenu par un mécanisme de partage de charges entre trois éléments, à savoir une cellule de référence à l'état haut, une cellule de référence à l'état bas et ladite ligne capacitive préchargée au potentiel prédéterminé.

Selon une autre variante de l'invention, on active les deux cellules de référence au cours de la phase de lecture et de rafraîchissement, de façon à précharger les deux cellules de référence avec deux potentiels intermédiaires respectivement égaux aux tensions de mémorisation d'état haut et d'état bas. Puis, on désactive la cellule-mémoire rafraîchie tout en maintenant les deux cellules de référence activées. On précharge la ligne de bit et la ligne de bit de référence à une tension de précharge égale à la demi somme de la tension de mémorisation d'état haut et de la tension de mémorisation d'état bas, puis on désactive les deux cellules de référence et on les relie à ladite métallisation capacitive portée audit potentiel prédéterminé.

En d'autres termes, selon cette variante la cellule-mémoire rafraîchie est désélectionnée, mais les cellules de référence restent connectées à leur ligne de bit respective. Le système constitué des lignes de bit et des cellules de référence est ensuite préchargé, par exemple par un mécanisme d'égalisation de façon à obtenir une précharge de la ligne de bit et de la ligne de bit de référence à la valeur Vdd/2 (cette valeur d'égalisation est alors indépendante de la donnée lue). Le potentiel de précharge final des cellules de référence est alors obtenu par un partage de charge entre les cellules de référence préalablement préchargées à Vdd/2, et ladite ligne capacitive préchargée au potentiel prédéterminé.

Quelle que soit la variante utilisée, on active les cellules de référence principale et secondaire au cours de la phase de lecture et de rafraîchissement, de façon à les précharger à deux états opposés (potentiels intermédiaires), puis on les désactive et on les relie à la ligne capacitive préchargée du potentiel prédéterminé.

Par ailleurs, quelle que soit la variante utilisée, la valeur du potentiel de précharge final des cellules de référence est indépendant de la tension de précharge et de la valeur capacitive des cellules-mémoires. Il ne dépende que des tensions de mémorisation d'état haut et d'état bas.

L'invention propose également un dispositif de mémoire vive dynamique, comprenant :
- un plan-mémoire comportant des colonnes formées chacune d'une ligne de bit et d'une ligne de bit de référence, sur lesquelles sont connectées des rangées de cellule-mémoire,
- un amplificateur commandable de lecture / réécriture connecté sur chaque colonne du plan-mémoire,
- des moyens commandables de précharge de colonne, connectés sur chaque colonne pour précharger la ligne de bit et la ligne de bit de référence de ladite colonne,
- des paires de cellules de référence respectivement connectées sur les lignes de bit et les lignes de bit de référence des colonnes, une métallisation principale d'activation de toutes les cellules de référence connectées sur les lignes de bit de référence, une métallisation secondaire d'activation de toutes les cellules de référence connectées sur les lignes de bit,
- des moyens commandables de précharge des cellules de référence, comportant des paires de transistors de liaison respectivement connectées entre les paires de cellules de référence, une métallisation de commande de tous les transistors de liaison, une métallisation capacitive distincte des lignes de bit et des lignes de bit de référence et connectées à tous les noeuds communs respectifs des paires de transistors de liaison, et des moyens pour porter la métallisation capacitive d'un potentiel prédéterminé ; ces moyens de précharge des cellules de référence étant aptes à précharger, à la suite d'une phase de lecture et de rafraîchissement des contenus des cellules-mémoire d'une rangée du plan-mémoire, les deux cellules de référence de chaque paire à une tension de précharge finale choisie inférieure ou supérieure, en fonction de la technologie NMOS ou PMOS utilisée à la demi somme de la tension de mémorisation d'état haut et de la tension de mémorisation d'état bas, et
- des moyens de commande aptes à commander l'amplificateur de lecture / réécriture, les moyens de précharge de colonnes et les moyens de précharge des cellules de référence.

Selon un mode de réalisation de l'invention, les moyens de commande sont aptes à activer la cellule de référence principale et la cellule de référence secondaire de chaque paire, au cours de la phase de lecture et de rafraîchissement des cellules-mémoire de façon à précharger les cellules de référence respectivement à deux potentiels intermédiaires prédéterminés. Puis, les moyens de commande sont aptes à désactiver les deux cellules de référence et à commander les transistors de liaison de façon à les rendre passants et relier ainsi les deux cellules de référence de chaque paire, à ladite métallisation capacitive ayant le potentiel prédéterminé, de façon à précharger les deux cellules de référence à ladite tension de précharge finale.

Selon un mode de réalisation de l'invention, le potentiel de la métallisation capacitive est nul et les moyens de précharge des cellules de référence comportent alors un transistor auxiliaire, commandable par les moyens de commande, et aptes à relier cette métallisation capacitive à la masse.

Selon un mode de réalisation de l'invention, la métallisation capacitive comporte une métallisation et un nombre prédéterminé de condensateurs identiques ayant chacun une valeur capacitive égale à celle de la cellule-mémoire, et tous connectés en parallèle entre ladite métallisation et la masse. Dans le cas où l'on souhaite obtenir une tension de précharge des cellules de référence égale à Vdd/3 par exemple, on choisira avantageusement un nombre de condensateurs identiques égal au nombre de colonnes.

D'autres avantages et caractéristiques de l'invention apparaîtront à l'examen de la description détaillée de mode de mise en oeuvre et de réalisation, nullement limitatifs, et des dessins annexés sur lesquels :
- la figure 1 illustre schématiquement l'architecture d'une mémoire vive dynamique selon l'invention,
- la figure 2 représente un chronogramme temporel illustrant une première variante d'un procédé selon l'invention dans le cas où un 0 logique est stocké dans une cellule-mémoire de la mémoire,
- la figure 3 représente un chronogramme temporel illustrant la première variante du procédé selon l'invention dans le cas où un "1" logique est stocké dans la cellule-mémoire, et
- la figure 4 représente un chronogramme temporel partiel illustrant une deuxième variante d'un procédé selon l'invention.

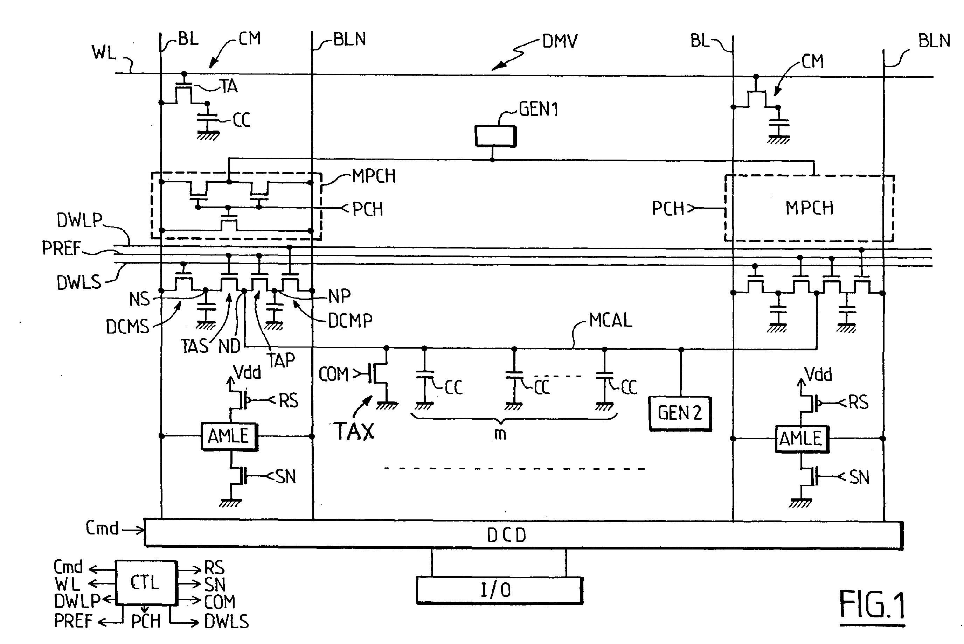

Sur la figure 1, la référence DMV désigne d'une façon générale un dispositif de mémoire vive selon l'invention. Ce dispositif de mémoire vive comprend un plan-mémoire comportant des cellules-mémoire CM organisées en lignes et en colonnes.

Chaque cellule-mémoire CM est ici une cellule-mémoire comportant un transistor d'accès TA et un condensateur de stockage CC. Bien entendu, l'invention n'est pas limitée à ce type de cellule-mémoire vive dynamique.

Toutes les cellules CM d'une même rangée peuvent être simultanément activées par un signal d'activation WL se propageant sur une ligne de mot ("word line" en langue anglaise). En effet, les grilles des transistors TA de ces cellules-mémoire CM sont connectées à cette ligne de mot WL. Par ailleurs, toutes les cellules de la rangée sont respectivement reliées à des métallisations de colonne BL ou ligne de bit (bit line).

A chaque ligne de bit BL est par ailleurs associée une ligne de bit immédiatement adjacente BLN, communément appelée par l'homme du métier ligne de bit de référence ("bit line not" en langue anglaise). Ces lignes de bit BLN permettent de connecter en quinconce d'autres rangées de cellules-mémoire. Bien entendu, pour une cellule-mémoire connectée sur une ligne de bit BLN, la ligne de bit BL fait alors office de ligne de bit de référence.

Chaque colonne du plan-mémoire est donc formée ici d'une ligne de bit BL et d'une ligne de bit de référence BLN.

Au pied de chaque colonne, est prévu un décodeur colonne DCD de structure classique et connue en soi, commandé par un signal de décodage de colonne Cmd. Ce décodeur colonne DCD permet de sélectionner l'une des colonnes du plan-mémoire afin de permettre la délivrance à l'interface de sortie I/O du dispositif de mémoire vive, du contenu de la cellule-mémoire placée à l'intersection de la colonne sélectionnée et de la rangée sélectionnée.

Le dispositif de mémoire vive DMV comporte par ailleurs des moyens commandables de précharge de colonne MPCH, de structure classique et connue en soi. Ces moyens MPCH sont par exemple ici formés par trois transistors commandés par le signal PCH. Ces moyens de précharge sont en fait ici des moyens de "pincement"de la ligne de bit BL et de la ligne de bit de référence BLN d'une colonne, et permettent lors du pincement, c'est-à-dire lorsque les trois transistors sont passants, d'égaliser le potentiel de la ligne de bit et de la ligne de bit de référence.

Tous les moyens de précharge MPCH du dispositif de mémoire vive DMV peuvent être connectés à un générateur GEN1 dont on reviendra plus en détail ci-après sur la fonction.

Le dispositif de mémoire vive DMV comporte par ailleurs, de façon classique, un amplificateur commandable de lecture / réécriture AMLE connecté sur chaque colonne du plan-mémoire. Plus précisément, cet amplificateur de lecture / réécriture est connecté entre la ligne de bit BL et la ligne de bit de référence BLN de la colonne. La structure d'un tel amplificateur de lecture / réécriture est connue de l'homme du métier, notamment par la demande de brevet français No. 2,768,847. Cet amplificateur de lecture / réécriture est classiquement commandé par deux signaux successifs de lecture SN et de réécriture RS, communément dénommés respectivement sense et "restore" en langue anglaise.

Outre les moyens qui viennent d'être décrits, le dispositif de mémoire vive DMV selon l'invention comporte une paire de cellules de référence connectées sur la ligne de bit et la ligne de bit de référence de chaque colonne. Plus précisément, cette paire de cellules de référence comporte une cellule de référence dite "principale" DCMP, connectée sur la ligne de bit de référence BLN. La paire de cellules de référence comporte également une cellule de référence dite "secondaire" DCMS connectée sur la ligne BL. Les deux cellules de référence sont par ailleurs connectées ensemble en un noeud ND.

Pour une cellule-mémoire CM du plan-mémoire, connectée sur la ligne de bit BL, on désigne par "principale" la cellule de référence connectée sur la ligne de bit de référence et par "secondaire", la cellule de référence connectée sur la ligne de bit. Bien entendu, pour une cellule-mémoire CM qui serait connectée sur la ligne de bit de référence BLN, la cellule de référence principale associée à cette cellule-mémoire serait la cellule DCMS et la cellule de référence secondaire serait la cellule DCMP.

Chaque cellule de référence secondaire DCMS comporte un transistor d'accès dont la grille est connectée sur une métallisation d'activation dite métallisation secondaire d'activation DWLS, qui est commune à l'ensemble du plan-mémoire.

De même, chaque cellule de référence principale DCMP comporte un transistor d'accès dont la grille est connectée à une métallisation d'activation dite métallisation principale d'activation DWLP, également commune à l'ensemble du plan-mémoire.

Le transistor d'accès de chaque cellule de référence secondaire DCMS d'une colonne est connectée par ailleurs sur la ligne de bit BL, tandis que le transistor d'accès de la cellule de référence principale DCMP d'une colonne est connectée sur la ligne de bit de référence BLN. La troisième électrode du transistor d'accès d'une cellule de référence secondaire DCMS, à savoir le noeud NS, est connectée à la masse par l'intermédiaire d'un condensateur de stockage CC. De même, la troisième électrode du transistor d'accès de la cellule de référence principale DCMP est également connectée à la masse par l'intermédiaire d'un autre condensateur de stockage CC. En fait, les cellules de référence sont structurellement analogues aux cellules CM du plan-mémoire.

Le dispositif de mémoire vive DMV comporte par ailleurs des moyens commandables de précharge des cellules de référence DCMS et DCMP. Ces moyens commandables de précharge des cellules de référence comportent ici des paires de transistors dits de "liaison", TAS et TAP respectivement connectés entre les paires de cellules de référence DCMS et DCMP. Plus précisément, le transistor de liaison TAS est connecté au noeud NS de la cellule de référence DCMS tandis que le transistor de liaison TAP est connecté au noeud NP de la cellule de référence DCMP. Ces deux transistors de liaison possèdent par ailleurs un noeud commun qui est le noeud ND.

Les moyens de précharge des cellules de référence comportent également une métallisation PREF de commande de tous les transistors de liaison. En d'autres termes, les grilles de tous les transistors de liaison TAS et TAP sont toutes connectées sur la métallisation PREF.

Les moyens commandables de précharge des cellules de référence, comportent par ailleurs une métallisation capacitive, distincte des lignes de bit et des lignes de bit de référence et connectée à tous les noeuds communs respectifs ND des paires de transistors de liaison TAS et TAP.

Plus précisément, cette métallisation capacitive comporte ici une métallisation MCAL reliant tous les noeuds ND, ainsi qu'un nombre prédéterminé m de condensateurs identiques CC ayant chacun une valeur capacitive égale à celle de la cellule-mémoire CM, ces condensateurs identiques CC étant tous connectés en parallèle entre ladite métallisation MCAL et la masse.

Les moyens commandables de précharge des cellules de référence comportent également des moyens pour porter la métallisation capacitive à un potentiel prédéterminé. En l'espèce, il est prévu un transistor auxiliaire TAX, commandable sur sa grille par un signal de commande COM, et apte à relier la métallisation capacitive à la masse. En d'autres termes, la masse est ici le potentiel prédéterminé auquel sera portée la métallisation capacitive lors de la précharge des cellules de référence, comme on le verra plus en détails ci-après.

Les différentes métallisation WL, DWLP, PREF, DWLS véhiculent des signaux d'activation que l'on désigne pour des raisons de simplicité par les mêmes références que celles affectées aux métallisations. Ces différents signaux d'activation, ainsi que les signaux de commande SN, RS, COM, Cmd, sont délivrés par des moyens de commande CTL, qui peuvent être classiquement réalisés à base de portes logiques.

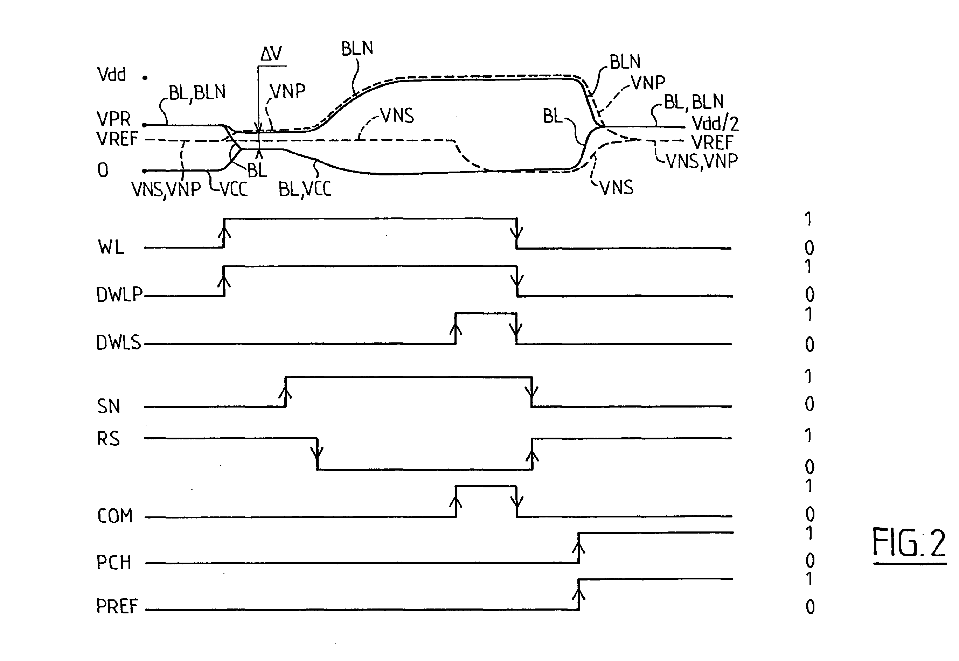

On va maintenant décrire plus en détails en se référant plus particulièrement aux figures 2 et suivantes le fonctionnement du dispositif de mémoire vive et plus particulièrement le mécanisme de précharge des cellules de référence.

Sur la figure 2, on suppose que la tension d'alimentation est égale à Vdd et que la cellule-mémoire CM stocke un 0 logique. On suppose par ailleurs, lors de l'accès en lecture de cette cellule-mémoire CM que la ligne de bit BL et la ligne de bit BLN ont été préalablement préchargées à une tension de précharge VPR qui peut être par exemple la tension Vdd/2. On suppose également que les cellules de référence secondaire et principale ont été préchargées à une tension de précharge VREF. En d'autres termes, les tensions VNS et VNP aux noeuds NS et NP, sont égales à cette tension VREF. On verra plus en détail ci-après comment on a obtenu ces différentes tensions de précharge. Cependant, il convient d'ores et déjà de noter que la tension de précharge VREF des cellules de référence est distincte de la tension Vdd/2. Elle est par exemple égale ici à Vdd/3.

Par ailleurs, puisque la cellule-mémoire CM stocke un 0 logique la tension VCC au noeud commun entre le condensateur de stockage CC et le transistor d'accès TA est nulle.

Pour procéder à la lecture de la cellule-mémoire, on sélectionne la rangée à laquelle appartient cette cellule-mémoire, c'est-à-dire que l'on active le signal WL qui passe à l'état logique 1 rendant le transistor TA passant. Simultanément, on active la cellule de référence principale DCMP associée à cette cellule-mémoire CM, en activant le signal de commande DWLP.

A ce stade, la cellule de référence DCMS n'est pas activée (signal DWLS à 0). Les signaux de commande COM, PCH, PREF, SN et RS sont par ailleurs inactivés. Il convient de noter ici que le signal RS est inactif à 1, et actif à 0 puisqu'il commande un transistor PMOS.

Lors de l'activation du signal WL et du signal DWLP, la cellule-mémoire CM est alors connectée à la ligne de bit BL qui était portée au potentiel VPR et la cellule de référence principale DCMP est reliée à la ligne de bit de référence BLN qui était également portée au potentiel VPR. La tension de la ligne de bit BL chute tandis que la tension VCC augmente, ces deux tensions venant s'égaliser à une valeur intermédiaire. De même, la tension de la ligne de bit de référence BLN décroît tandis que la tension VNP croît, ces deux tensions venant s'égaliser à une autre valeur intermédiaire. La tension VNS reste quant à elle égale à la tension de précharge VREF.

La tension de précharge VREF, la tension de précharge VPR sont choisies de façon à ce que l'écart de tension ΔV entre la tension VNP et la tension VL de la ligne de bit BL soit supérieur à la tension de décalage (offset) de l'amplificateur de lecture / réécriture AMLE. On active alors le signal SN, ce qui permet l'amplification de la différence de tension ΔV et une lecture de la donnée mémorisée. Puis, de façon classique, on active le signal RS, ce qui provoque une remontée, vers le potentiel Vdd, de la tension VNP et de la tension de la ligne de bit de référence BLN. Dans le même temps, le potentiel de la ligne de bit BL et la tension VCC chutent vers la masse. La donnée lue est alors réécrite dans la cellule-mémoire CM.

Au cours de cette phase de lecture / réécriture, c'est-à-dire avant la désactivation des signaux SN et RS, on active la cellule de référence secondaire en activant le signal d'activation DWLS. Cette montée à 1 du signal DWLS a pour conséquence de connecter effectivement la cellule de référence secondaire à la ligne de bit BL et par conséquent, de faire chuter la tension VNS vers la masse. A cet instant, les deux cellules de référence ont été préchargées à deux potentiels dits intermédiaires, à savoir le potentiel Vdd et le potentiel nul.

A l'issue de cette phase de lecture / réécriture, on désactive la cellule-mémoire CM, la cellule de référence principale, la cellule de référence secondaire, en faisant redescendre à 0 les signaux logiques d'activation correspondants. Puis, un peu après cette désactivation, on désactive les signaux SN et RS.

A cet instant, les cellules de référence sont isolées électriquement de la ligne de bit et de la ligne de bit de référence de la colonne.

Afin de préparer le plan-mémoire pour une requête ultérieure en lecture, on va maintenant précharger à nouveau la ligne de bit, la ligne de bit de référence et les cellules de référence. A cet égard, la précharge des lignes de bit s'effectue en activant le signal de commande de précharge PCH ce qui a pour effet de rendre passants les trois transistors de moyens de précharge MPCH et donc de "pincer" la ligne de bit et la ligne de bit de référence. Par conséquent, les tensions de la ligne de bit et de la ligne de bit de référence s'égalisent à la tension Vdd/2. Il convient de noter ici que le caractère parfaitement symétrique des cellules de référence garantit une parfaite égalité des capacités de part et d'autre, c'est-à-dire des capacités vues par la ligne de bit et la ligne de bit de référence. C'est cette parfaite égalité qui conduit à une égalisation parfaite à Vdd/2. Il convient de noter ici que cette valeur d'égalisation est indépendante de la donnée lue. Il convient encore de noter ici que si la tension VPR est différente de Vdd/2, il sera nécessaire de prévoir un générateur de tension connecté sur les lignes de bit et capable de générer l'excursion de tension enctre Vdd/2 et VPR.

Dans cette variante de mise en oeuvre, on va précharger les cellules de référence simultanément à la précharge des lignes de bit en activant le signal de précharge PREF.

Cependant, avant d'activer ce signal de précharge PREF, ce qui aura pour conséquence de rendre passants les deux transistors de liaison TAS et TAP, on a activé le signal de commande COM du transistor auxiliaire TAX ce qui a pour effet de décharger les condensateurs CC de la métallisation capacitive et par conséquent de porter le noeud ND à une tension nulle. Il convient de noter ici que l'instant d'activation du signal COM est sans importance pourvu qu'il soit effectué avant l'activation du signal PREF.

Lors de cette activation du signal PREF, les deux tensions VNS et VNP s'égalisent alors à la tension VREF.

L'équation du partage de charges au noeud ND lors de l'activation du signal PREF, conduit à un rapport VREF / Vdd égal à 1/(2+m/nc).

Dans cette formule, m est le nombre de condensateurs CC connectés sur la métallisation MCAL et nc est le nombre de colonnes. On voit donc que si le rapport m/nc est égal à 1, c'est-à-dire si l'on a autant de condensateurs CC que de colonnes du plan-mémoire, alors la tension VREF est égale à Vdd/3.

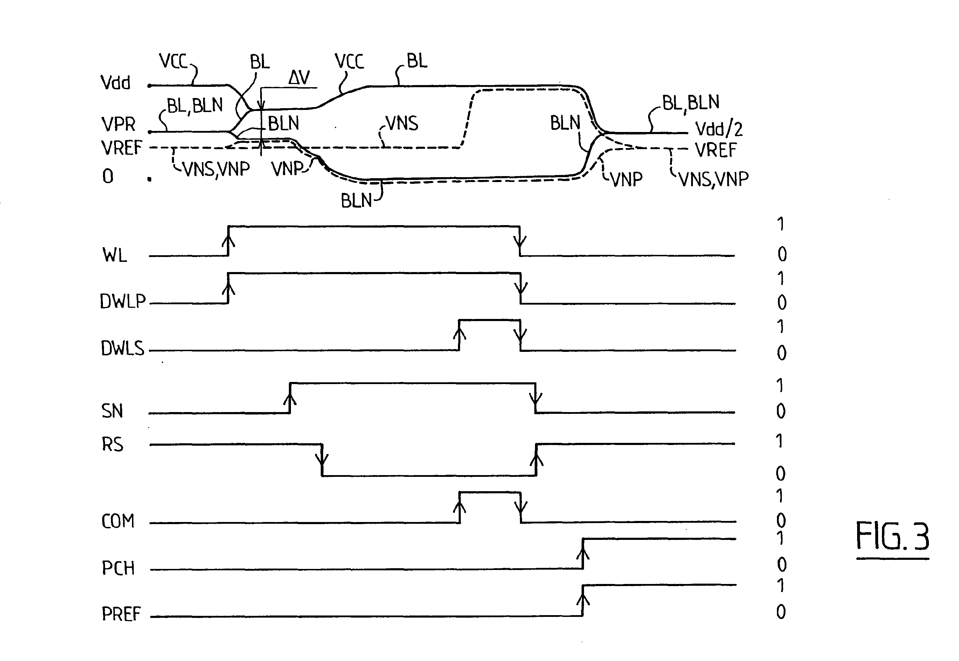

La figure 3 illustre un chronogramme temporel analogue à celui de la figure 2 mais applicable pour le cas où la cellule-mémoire CM stocke un "1" logique.

On ne décrira ici que les différences entre le chronogramme de la figure 3 et celui de la figure 2.

Avant l'activation du signal WL, c'est-à-dire avant sélection de la cellule-mémoire, la tension VCC est égale à la tension Vdd puisque la cellule contient un 1 logique.

Lors de l'activation du signal WL et du signal DWLP, la tension VCC et la tension de la ligne de bit BL s'égalisent. De même, la tension VNP et la tension de la ligne de bit de référence BLN s'égalisent.

Il convient de noter ici que le fait que la tension de précharge VREF des cellules de référence soit inférieure à la valeur Vdd/2, par exemple égale à Vdd/3, présente un avantage dans le cas où la mémoire présente des courants de fuite non négligeables. En effet, avec de tels courants de fuite, la tension VCC n'est plus égale à Vdd au moment de la sélection de la cellule-mémoire mais est égale à une tension inférieure à Vdd en raison de ces courants de fuite. En conséquence, la tension d'égalisation entre la tension VCC et la tension de la ligne de bit BL sera par conséquent plus faible. Et, si la tension VREF était égale à Vdd/2, l'écart de tension ΔV après activation du signal WL et du signal DWLP serait plus réduit que dans le cas où la tension VREF initiale est inférieure à Vdd/2.

L'invention permet donc avec un choix convenable de VREF, de prendre en compte les courants de fuite pour obtenir une différence de tension ΔV suffisante et supérieure à la tension d'offset de l'amplificateur de lecture / réécriture.

Lors de l'activation du signal SN et du signal RS, la ligne de bit BL et la tension VCC remontent à Vdd alors que cette fois-ci, la tension VNP et la tension de la ligne de bit de référence BLN chutent à la masse.

Lors de l'activation du signal DWLS, la tension VNS monte cette fois-ci à Vdd. A cet instant, les tensions VNS et VNP des deux cellules de référence sont préchargées aux deux potentiels intermédiaires respectivement égaux à Vdd et 0, mais cette fois-ci, contrairement au cas de la figure 2, c'est la cellule de référence secondaire qui mémorise un état haut tandis que la référence de la cellule de référence principale mémorise un état bas.

Le reste du procédé se déroule comme expliqué en référence à la figure 2.

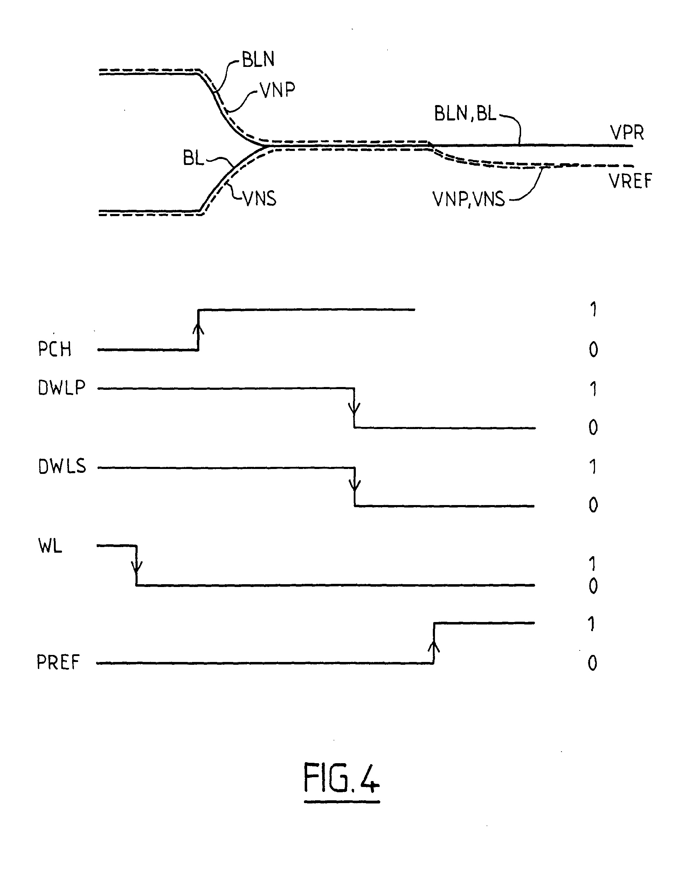

On se réfère maintenant à la figure 4 pour décrire une autre mise en oeuvre du procédé selon l'invention dans laquelle la cellule-mémoire rafraîchie est désélectionnée, mais les cellules de référence restent connectées à leurs lignes de bit respectives.

Sur le chronogramme partiel de la figure 4, on se place après l'activation du signal DWLS c'est-à-dire lorsque les deux cellules de référence ont été préchargées à leur potentiel intermédiaire respectivement égaux à Vdd et 0.

On désélectionne alors la cellule-mémoire en faisant retomber à 0 le signal WL. On précharge ensuite la ligne de bit et la ligne de bit de référence en activant le signal PCH ce qui provoque l'égalisation d'une part des tensions de la ligne de bit BL et de la ligne de bit BLN mais également des tensions VNS et VNP puisque les cellules de référence restent connectées à leurs lignes de bit respectives.

La parfaite égalité des capacités vue par la ligne de bit et la ligne de bit de référence, garantit l'égalisation parfaite à la tension Vdd/2.

On désélectionne ensuite les cellules de référence en faisant retomber à 0 les signaux DWLP et DWLS. Puis on active la précharge des cellules de référence en activant le signal PREF. Il se produit alors le mécanisme de partage de charge entre les deux cellules de référence préalablement chargées à Vdd/2 et la métallisation capacitive portée à la masse, ce qui conduit à une chute des tensions VNP et VNS jusqu'à la tension de précharge VREF des cellules de référence.

Bien entendu, tout ce qui vient d'être décrit pour des cellules-mémoire et des cellules de référence réalisées en technologie NMOS c'est-à-dire avec des transistors NMOS réalisés par exemple dans un substrat P relié à la masse (voire polarisé négativement), s'applique pour des cellules-mémoire et des cellules de référence réalisées en technologique PMOS, c'est-à-dire avec des transistors PMOS réalisés dans un substrat N relié à la tension d'alimentation Vdd (voire polarisée à une tension supérieure à Vdd). L'homme du métier saura effectuer les ajustements nécessaires par rapport à ce qui vient d'être décrit pour une technologie NMOS. Plus particulièrement, dans une technologie PMOS, le problème des fuites de courant se traduit cette fois-ci par une remontée de la tension de mémorisation d'état bas initialement à la masse. En conséquence, pour une technologie PMOS, on choisira une tension de précharge VREF supérieure à la demi somme de la tension d'état haut (par exemple Vdd) et de la tension d'état bas (par exemple la masse). On choisira par exemple une tension égale à 2/3 de Vdd.

Pour une technologie 0,18µ (Vdd = 1,8 Volt), les valeurs Vdd/3 et 2Vdd/3 choisies à titre d'exemple conviennent parfaitement puisque généralement, les tensions de décalage des amplificateurs de lecture / réécriture sont de l'ordre de 50 mvolts.

On a également représenté sur la figure 1, deux générateurs de tension continue GEN1 et GEN2. Ces deux générateurs GEN1 et GEN2, respectivement connectés au moyen de précharge MPCH et à la métallisation MCAL servent à maintenir les tensions de précharge respectives des lignes de bit et des cellules de référence, c'est-à-dire les tensions VPR et VREF dans le cas par exemple d'inutilisations prolongées des mémoires et ce, afin de limiter les effets de fuite de courant. Ceci étant, ces générateurs, et notamment le générateur GEN2 sont des générateurs extrêmement simples, ne présentant aucune contrainte dynamique. Ainsi, le générateur GEN2 n'a rien à voir avec le générateur utilisé dans l'art antérieur pour précharge la cellule de référence principale.

## Revendications

1. Procédé de commande d'un accès en lecture d'une cellule-mémoire d'un plan-mémoire d'un dispositif de mémoire vive dynamique, ladite cellule-mémoire (CM) étant connectée à une ligne de bit (BL) du plan-mémoire et associée à une cellule de référence principale (DCMP) connectée à une ligne de bit de référence (BLN), comportant une phase de lecture et de rafraîchissement du contenu de la cellule-mémoire et une phase de précharge de la ligne de bit, de la ligne de bit de référence et de la cellule de référence principale en vue d'un accès en lecture ultérieur, **caractérisé par le fait qu'**on active, au cours de la phase de lecture et de rafraîchissement de la cellule-mémoire, la cellule de référence principale (DCMP) et une cellule de référence secondaire (DCMS) connectée à la ligne de bit et, après avoir désactivé les deux cellules de référence, on les précharge à une tension de précharge finale (VREF) choisie inférieure ou supérieure, en fonction de la technologie NMOS ou PMOS utilisée, à la demi-somme de la tension de mémorisation d'état haut et de la tension de mémorisation d'état bas, en les reliant à une ligne capacitive (MCAL) distincte de la ligne de bit et de la ligne de bit de référence et ayant un potentiel prédéterminé et une valeur capacitive prédéterminée.

2. Procédé selon la revendication 1, **caractérisé par le fait que** la tension de précharge finale (VREF) est égale au tiers de la somme de la tension de mémorisation d'état haut et de la tension de mémorisation d'état bas, pour une technologie NMOS et au deux tiers de cette somme pour une technologie PMOS.

3. Procédé selon la revendication 1 ou 2, **caractérisé par le fait qu'**on active les deux cellules de référence au cours de la phase de lecture et de rafraîchissement de façon à précharger les deux cellules de référence (DCMP, DCMS) avec deux potentiels intermédiaires de précharge respectivement égaux aux tensions de mémorisation d'état haut (Vdd) et d'état bas (O), puis on désactive la cellule-mémoire rafraîchie (CM) et les deux cellules de référence, avant de précharger la ligne de bit et la ligne de bit de référence, et de relier les deux cellules de référence à ladite métallisation capacitive portée audit potentiel prédéterminé.

4. Procédé selon la revendication 1 ou 2, **caractérisé par le fait qu'**on active les deux cellules de référence au cours de la phase de lecture et de rafraîchissement de façon à précharger les deux cellules de référence (DCMP, DCMS) avec deux potentiels intermédiaires respectivement égaux aux tensions de mémorisation d'état haut et d'état bas, puis on désactive la cellule-mémoire rafraîchie (CM) tout en maintenant les deux cellules de référence activées, on précharge la ligne de bit et la ligne de bit de référence à une tension de précharge égale à la demi-somme de la tension de mémorisation d'état haut et de la tension de mémorisation d'état bas, puis on désactive les deux cellules de référence et on les relie à ladite métallisation capacitive portée audit potentiel prédéterminé.

5. Procédé selon l'une des revendications précédentes, **caractérisé par le fait que** le potentiel prédéterminé de la ligne capacitive (MCAL) est nul, et **par le fait qu'**on relie cette ligne capacitive à la masse avant de relier les deux cellules de référence à cette ligne capacitive.

6. Procédé selon l'une des revendications précédentes, **caractérisé par le fait que** la ligne capacitive comporte un nombre prédéterminé (m) de condensateurs identiques (cc) ayant chacun une valeur capacitive égale à celle de la cellule-mémoire.

7. Dispositif de mémoire vive dynamique, **caractérisé par le fait qu'**il comprend
- un plan-mémoire comportant des colonnes formées chacune d'une ligne de bit (BL) et d'une ligne de bit de référence (BLN), sur lesquelles sont connectées des rangées de cellules-mémoire,
- un amplificateur commandable de lecture/réécriture (AMLE) connecté sur chaque colonne du plan-mémoire,
- des moyens commandables de précharge de colonne (MPCH), connectés sur chaque colonne, pour précharger la ligne de bit et la ligne de bit de référence de ladite colonne,
- des paires de cellules de référence (DCMP, DCMS) respectivement connectées sur les lignes de bit et les lignes de bit de référence des colonnes, une métallisation principale d'activation (DWLP) de toutes les cellules de références connectées sur les lignes de bit de référence, une métallisation secondaire d'activation (DWLS) de toutes les cellules de références connectées sur les lignes de bit,
- des moyens commandables de précharge des cellules de référence, comportant des paires de transistors de liaison (TAS, TAP) respectivement connectés entre les paires de cellules de référence, une métallisation de commande (PREF) de tous les transistors de liaison, une métallisation capacitive (MCAL) distincte des lignes de bits et des lignes de s de référence,et connectée à tous les noeuds communs respectifs (ND) des paires de transistors de liaison, et des moyens (TAX) pour porter la métallisation capacitive à un potentiel prédéterminé, ces moyens de précharge étant aptes à précharger, à la suite d'une phase de lecture et de rafraîchissement des contenus des cellules-mémoire d'une rangée du plan-mémoire, les deux cellules de référence de chaque paire à une tension de précharge finale (VREF) choisie inférieure ou supérieure, en fonction de la technologie NMOS ou PMOS utilisée, à la demi-somme de la tension de mémorisation d'état haut et de la tension de mémorisation d'état bas, et
- des moyens de commande (CTL) aptes à commander l'amplificateur de lecture/réécriture, les moyens de précharge de colonne et des cellules de référence.

8. Dispositif selon la revendication 7, **caractérisé par le fait que** tension de précharge finale (VREF) est égale au tiers de la somme de la tension de mémorisation d'état haut et de la tension de mémorisation d'état bas, pour une technologie NMOS et au deux tiers de cette somme pour une technologie PMOS.

9. Dispositif selon la revendication 7 ou 8, **caractérisé par le fait que** les moyens de commande (CTL) sont aptes à activer la cellule de référence principale et la cellule de référence secondaire de chaque paire, au cours de la phase de lecture et de rafraîchissement des cellules-mémoire de façon à précharger les deux cellules de référence respectivement à deux potentiels intermédiaires prédéterminés, puis à désactiver les deux cellules de référence et à commander les transistors de liaison (TAS, TAP) de façon à les rendre passants et à relier ainsi les deux cellules de référence de chaque paire à ladite métallisation capacitive ayant le potentiel prédéterminé, de façon à précharger les deux cellules de référence à ladite tension de précharge finale (VREF).

10. Dispositif selon l'une des revendications 7 à 9, **caractérisé par le fait que** le potentiel de la métallisation capacitive est nul, et **par le fait que** les moyens de précharge des cellules de référence comportent un transistor auxiliaire (TAX), commandable par les moyens de commande, et apte à relier cette métallisation capacitive à la masse.

11. Dispositif selon l'une des revendications 7 à 10, **caractérisé par le fait que** la métallisation capacitive comporte une métalisation et un nombre prédéterminé (m) de condensateurs identiques (cc) ayant chacun une valeur capacitive égale à celle de la cellule-mémoire, et tous connectés en parrallèle entre ladite métallisation et la masse.
